# EUROPÄISCHE PATENTSCHRIFT

(11) **EP 3 474 642 B1**
(45) Veröffentlichungstag und Bekanntmachung des Hinweises auf die Patenterteilung: **03.04.2024**
(21) Anmeldenummer: 18183310.4
(22) Anmeldetag: 13.07.2018
(51) Int. Cl.: H05K 3/28, C09D 11/101, C09D 11/30, G03F 7/028, H05K 3/34, G03F 7/038, G03F 7/027, C08L 63/00

(54) **LÖTSTOPPLACK ZUM AUFBRINGEN MITTELS TINTENSTRAHLTECHNOLOGIE**
SOLDER RESIST FOR APPLYING USING INKJET TECHNOLOGY
MASQUAGE POUR LA SOUDURE DESTINÉ À L'APPLICATION AU MOYEN DE LA TECHNOLOGIE DU JET D'ENCRE

(30) Priorität: 23.10.2017 EP 17197821
(43) Veröffentlichungstag der Anmeldung: 24.04.2019
(73) Patentinhaber: Peters Research GmbH & Co. Kommanditgesellschaft, 47906 Kempen (DE)
(72) Erfinder: Schwartz, Ralf, 47906 Kempen (DE); Tekath, Johannes, 48653 Coesfeld (DE)
(74) Vertreter: Dr. Stark & Partner Patentanwälte mbB

(56) Entgegenhaltungen:
- EP-A1- 3 214 142
- US-A- 5 070 002
- US-A- 5 886 101
- US-A1- 2006 019 077
- US-A1- 2009 163 615
- ITOH H ET AL: "SYNTHESIS OF NEW HYBRID MONOMERS AND OLIGOMERS CONTAINING CATIONIC AND RADICAL POLYMERIZABLE VINYL GROUPS AND THEIR PHOTOINITIATED POLYMERIZATION", JOURNAL OF POLYMER SCIENCE, POLYMER CHEMISTRY EDITION, INTERSCIENCE PUBLISHERS, NEW YORK, NY, US, Bd. 34, Nr. 2, 30. Januar 1996 (1996-01-30), Seiten 217-225, XP002028011, ISSN: 0360-6376
- Ute Löffelmann ET AL: "Solvent-free inkjet printing process for the fabrication of conductive, transparent, and flexible ionic liquid-polymer gel structures", JOURNAL OF POLYMER SCIENCE PART B: POLYMER PHYSICS, vol. 50, no. 1, 1 January 2012 (2012-01-01), pages 38-46, XP055589714, US ISSN: 0887-6266, DOI: 10.1002/polb.22346

## Beschreibung

Die Erfindung betrifft einen Lötstopplack zum Aufbringen mittels Tintenstrahltechnologie, wobei die Zusammensetzung des Lötstopplacks eine Wärmebeständigkeit für ein Tintenstrahlsystem besitzt.

Aus der Praxis sind derartige Lötstopplacke bekannt, die mittels Tintenstrahldruckverfahren strukturiert auf Leiterplatten für elektronische Schaltungen appliziert werden und anschließend zu einem thermisch stabilen und chemikalienfesten Lackfilm vernetzbar sind. Diese Lötstopplacke erfüllen auf einer Leiterplatte mehrere verschiedene Funktionen. Zum einen wird hierdurch ein Schutz der Leiterplatte vor Korrosion und mechanischen Beschädigungen bewirkt. Zum anderen verhindert der Lötstopplack beim Löten das Benetzen der Leiterplatte mit dem Lot in denjenigen Bereichen der Leiterplatte, die mit dem Lötstopplack überzogen sind. Auch werden durch den Lötstopplack elektrische Eigenschaften wie beispielsweise die Durchschlagsfestigkeit verbessert.

Die aus der Praxis bekannten Lötstopplacke werden üblicherweise mittels Sieb- oder Schablonendruckverfahren in der gewünschten Struktur auf die Au-ßenlagen gedruckter elektronischer Schaltungen auf einer Leiterplatte gedruckt. Dabei ist jedoch von Nachteil, dass mittels Siebdruckverfahren nur eine Darstellung von relativ groben Strukturen von > 200 µm möglich ist.

Die für Sieb- oder Schablonendruckverfahren verwendeten Lötstopplacke basieren beispielsweise auf Bindemitteln aus der Gruppe der Epoxi-Novolacke und umfassen auch geeignete Härter, beispielsweise aus der Gruppe der Amine, so dass die Lötstopplacke mittels thermischer Behandlung zu einem thermisch stabilen und chemikalienfesten Lackfilm vernetzbar sind.

Eine andere Art solcher Lötstopplacke basiert auf UV-härtbaren Oligomeren und Monomeren mit acryloylfunktionellen Gruppen. Hierbei erfolgt die Vernetzung mittels UV-Strahlung, durch die in dem Lötstopplack vorhandene geeignete Fotoinitiatoren eine radikalische Polymerisation initiieren.

Auch sind sogenannte fotostrukturierbare Lötstopplacke bekannt, bei denen nach physikalischer Trocknung des Lackfilmes die Strukturierung durch einen strukturgebenden Belichtungsvorgang mit anschließendem Entwicklungsprozess erfolgt. Dabei erfolgt die Beschichtung vollflächig mittels Siebdruck, Vorhanggießverfahren oder Sprühapplikation. Mit diesem Verfahren können auch feinere Strukturen, teilweise von < 50 µm, realisiert werden. Allerdings sind diese Verfahren recht aufwändig, weil neben dem Auftragsverfahren und der Trocknung zumindest ein Entwicklungsprozess erforderlich ist, um die unbelichteten Bereiche freizustellen. Weiterhin nachteilig ist, dass dieser Entwicklungsprozess in Lösemitteln oder in alkalischen Medien erfolgt, wobei das Entwicklermedium anschließend aufwendig aufbereitet oder entsorgt werden muss. Zudem wird bei solchen Verfahren ein Anteil des Lacks abentwickelt und verbleibt somit nicht funktionell auf der Leiterplatte, was sowohl hinsichtlich der Kosten als auch in Bezug auf Ressourcen und die Umwelt negativ zu beurteilen ist.

Für das direkte Erzeugen feinster Lackstrukturen bietet sich das Tintenstrahldruckverfahren mittels eines Tintenstrahlsystems an. Hierfür muss der Lötstopplack eine deutlich niedrigere Viskosität aufweisen. Die Verwendung der klassischen höhermolekularen Harze würde die Mitverwendung größerer Lösemittelmengen erforderlich machen, was sich nachteilig auf den Festkörper sowie die erzielbare Trockenschicht und damit auch auf die Prozessgeschwindigkeit und die Strukturgenauigkeit auswirken würde.

Auch würde die Möglichkeit bestehen, die Temperatur des Lötstopplacks beim Drucken zu erhöhen und hierdurch eine Viskositätserniedrigung zu erreichen, woraus jedoch eine deutliche Einschränkung der geeigneten Zusammensetzung resultiert, da viele Komponenten in Kombination mit anderen notwendigen Bestandteilen der Zusammensetzung nicht ausreichend temperaturstabil sind. Aus der US 2009/0163615 A1 ist ein Lötstopplack vorbekannt, der flüchtige Lösemittel umfasst.

In der Druckschrift "Synthesis of New Hybrid Monomers and Oligomers Containing Cationic and Radical Polimerizable Vinyl groups and Their Photoinitiated Polymerization" (Journal of polymer science, polymer chemistry edition, Interscience Publishers, New York, NY, US, Bd. 34, Nr. 2, 30. Januar 1996, Seiten 217-225, XP002028011, ISSN: 0360-6376) sind Vorteile von radikalisch und kationisch härtbaren Komponenten beschrieben.

In der EP 3 214 142 A1 sind härtbare Zusammensetzungen für ein Ink-Jet-Verfahren beschrieben, welche eine photohärtbare Verbindung und eine thermisch härtbare Verbindung umfassen und weiterhin Lösungsmittel umfassen können.

US 2006/0019077 A1 offenbart einen Lötstopplack zum Aufbringen mittels Tintenstrahltechnologie, wobei die Zusammensetzung des Lötstopplacks umfasst: eine kationisch härtbare Vinylether-Verbindung, eine radikalisch härtbare Acrylatester-Verbindung, einen radikalisch initiierenden Fotopolymerisationsinitiator, einen kationisch initiierenden Fotopolymerisationsinitiator, und wobei die Zusammensetzung frei von flüchtigen Lösungsmittel ist.

Aufgabe der Erfindung ist es, die vorgenannten Nachteile zu vermeiden und einen Lötstopplack anzugeben, mit dem kostengünstig und ressourcenschonend auch feinere Strukturen, teilweise von < 50 µm, realisierbar sind.

Diese Aufgabe wird bei einem gattungsgemäßen Lötstopplack dadurch gelöst, dass die Zusammensetzung wenigstens folgende Komponenten umfasst:
- zumindest ein Monomer mit wenigstens einer kationisch härtbaren Gruppe und/oder zumindest ein Oligomer mit wenigstens einer kationisch härtbaren Gruppe,
- zumindest ein Monomer mit wenigstens einer radikalisch härtbaren Gruppe und/oder zumindest ein Oligomer mit wenigstens einer radikalisch härtbaren Gruppe,
- zumindest ein Monomer mit wenigstens einer thermisch härtbaren Gruppe und/oder zumindest ein Oligomer mit wenigstens einer thermisch härtbaren Gruppe,
- mindestens einen radikalisch initiierenden Fotopolymerisationsinitiator und
- mindestens einen kationisch initiierenden Fotopolymerisationsinitiator,

wobei die Zusammensetzung frei ist von flüchtigen Lösemitteln, die im ausgehärteten Zustand der Zusammensetzung nicht mehr in der Zusammensetzung vorhanden sind,
und wobei weiterhin zum einen zumindest eine kationisch härtbare Gruppe ausgewählt ist aus einer Gruppe, welche die cycloaliphatischen Epoxide und die Vinylether umfasst,
und zum anderen zumindest eine radikalisch härtbare Gruppe ausgewählt ist aus einer Gruppe, welche die Acrylatester, die Methacrylatester und die Vinylether umfasst,
wobei außerdem einerseits die Zusammensetzung Moleküle umfasst, in denen jeweils zumindest eine kationisch härtbare Komponente und wenigstens eine radikalisch härtbare Komponente gemeinsam vorhanden sind
und andererseits die einzelnen Komponenten der Zusammensetzung derart ausgewählt und ausgebildet sind, dass der Lötstopplack beim Aushärten ein interpenetrierendes Netzwerk, bestehend aus mindestens zwei Netzwerken, ausbildet.

Insoweit erlaubt die Verwendung niedrigviskoser niedermolekularer UVhärtbarer Monomere, Dimere oder anderer Oligomere den weitgehenden Verzicht auf flüchtige Verdünnungen wie auch eine Reduzierung solcher Reaktiv-Verdünnungen.

Durch die UV-Härtung ist eine sehr schnelle Polymerisation und damit eine Fixierung des Lackes möglich. Somit können feinste Strukturen gut dargestellt werden, da die Lacktropfen unmittelbar nach dem Auftreffen auf das Substrat schnell fixiert werden und nicht aufgrund ihrer niedrigen Viskosität zu stark verlaufen.

Die typischerweise eingesetzten UV-härtbaren Lacke hingegen benötigen zusätzlich zur UV-Vernetzung noch eine weitere thermische Vernetzung. Da die Polymerisierung von Monomeren durch UV-Strahlen jedoch lediglich relativ schwach vernetzte Filme ergibt, sind die erforderlichen Eigenschaften eines Lötstopplacks, wie thermische Beständigkeit und Chemikalienbeständigkeit, nicht gegeben. Demgegenüber benötigt die erfindungsgemäße Zusammensetzung nur wenig thermische Vernetzung. Die Vernetzung erfolgt im Wesentlichen durch Strahlenhärtung.

Die Verwendung von sowohl kationischen als auch radikalischen Fotopolymerisationsinitiatoren führt in einem ersten Aushärtungsschritt zu einer Ausbildung eines sogenannten interpenetrierenden Netzwerkes, wodurch sowohl die Lötstopplackeigenschaften verbessert und weiterhin auch Vorteile in den mechanischen Eigenschaften, wie Versprödungsbeständigkeit und Elastizitäten, im Vergleich zu einem einheitlichen Netzwerk, erreicht werden. Weiterhin sind auf diese Weise ausreichend niedrige Viskositäten, im Temperaturbereich von 20 °C bis 35 °C, erreichbar.

Vorzugsweise kann zumindest ein Oligomer mit wenigstens einer kationisch härtbaren Gruppe als ein Dimer ausgebildet sein.

Weiterhin kann zumindest ein Oligomer mit wenigstens einer radikalisch härtbaren Gruppe als ein Dimer ausgebildet sein.

Auch kann zumindest ein Oligomer mit wenigstens einer thermisch härtbaren Gruppe als ein Dimer ausgebildet sein.

Weiterhin kann zumindest eine thermisch härtbare Gruppe ausgewählt sein aus einer Gruppe, welche die Epoxide, die Polyole und die stickstoffhaltigen reaktiven Gruppen umfasst.

Bei einem bevorzugten Ausführungsbeispiel der Erfindung kann die Gesamtheit einer kationisch härtbaren Komponente und die Gesamtheit einer radikalisch härtbaren Komponente in entsprechenden Molekülen zusammen vorhanden sein. Alternativ kann der Anteil einer kationisch härtbaren Komponente und der Anteil einer radikalisch härtbaren Komponente, die in entsprechenden Molekülen zusammen vorhanden sind, auch 5 Gew.% bis 30 Gew.%, vorzugsweise 15 Gew.% betragen.

Die Volumenkontraktion, die bei einer rein radikalischen Polymerisation auftritt und bei 5 Gew.% bis 15 Gew.% liegen kann, wird durch die Kombination der beiden Härtungsmechanismen (radikalisch und kationisch) und Ausbildung des interpenetrierenden Netzwerkes verringert und führt somit zu einer
besseren Haftung, insbesondere auf metallischen und anderen kritischen Untergründen.

Vorzugsweise kann die Viskosität der Zusammensetzung (bei 20°C) 10 mPas bis 50 mPas, vorzugsweise 19 mPas, betragen, so dass eine ausreichende Viskosität für den Einsatz in einem Tintenstrahlsystem zum Aufbringen mittels Tintenstrahltechnologie gegeben ist.

Erfindungsgemäß kann der Anteil des zumindest einen Monomers mit wenigstens einer kationisch härtbaren Gruppe und/oder der Anteil des zumindest einen Oligomers mit wenigstens einer kationisch härtbaren Gruppe an der Zusammensetzung insgesamt 10 Gew.% bis 50 Gew.%, vorzugsweise 28 Gew.%, betragen.

Auch kann der Anteil des zumindest einen Monomers mit wenigstens einer radikalisch härtbaren Gruppe und/oder der Anteil des zumindest einen Oligomers mit wenigstens einer radikalisch härtbaren Gruppe an der Zusammensetzung insgesamt 10 Gew.% bis 70 Gew.%, vorzugsweise 35 Gew.%, betragen.

Weiterhin kann der Anteil des zumindest einen Monomers mit wenigstens einer kationisch härtbaren Gruppe und/oder der Anteil des zumindest einen Oligomers mit wenigstens einer thermisch kationisch härtbaren Gruppe an der Zusammensetzung insgesamt 5 Gew.% bis 30 Gew.%, vorzugsweise 14 Gew.%, betragen.

Vorzugsweise kann der Anteil des zumindest einen radikalisch initiierenden Fotopolymerisationsinitiator an der Zusammensetzung insgesamt 1 Gew.% bis 5 Gew.%, vorzugsweise 3 Gew.%, betragen.

Erfindungsgemäß kann der Anteil des zumindest einen kationisch initiierenden Fotopolymerisationsinitiator an der Zusammensetzung insgesamt 1 Gew.% bis 5 Gew.%, vorzugsweise 2,5 Gew.%, betragen.

Vorzugsweise kann die Zusammensetzung weiterhin 0,5 Gew.% bis 5 Gew.%, vorzugsweise 1,5 Gew.%, Pigmente und/oder Farbstoffe umfassen.

Auch kann die Zusammensetzung weiterhin 1 Gew.% bis 5 Gew.%, vorzugsweise 1,5 Gew.%, Additive, wie z. B. Lackadditive wie beispielsweise Netz- und Dispergierhilfsmittel, Entschäumer oder Mittel zur Reduktion der Oberflächenspannung, und/oder Füllstoffe umfassen.

Bevorzugt kann die Zusammensetzung und damit das so erhaltene interpenetrierende Netzwerk mit weiteren thermisch härtbaren Monomeren und/oder Oligomeren, vorzugsweise Dimeren, versehen sein und somit mittels einer nachträglich durchgeführten thermischen Härtung eine weitere Erhöhung der Netzwerkdichte und bessere Haftung bewirken.

Die thermische Aushärtung kann dabei bei mindestens 120 °C und bevorzugt bei 150 °C erfolgen und mittels einer gesteigerten Reaktionsgeschwindigkeit die zuvor durch UV-Strahlung initierte Vernetzung weiterführen und zu einer Vernetzung der thermisch härtbaren Epoxygruppen, mit Hilfe der durch die UV-Bestrahlung der kationischen Fotopolymerisation gebildeten Kationen, führen.

Ganz bevorzugt kann die Zusammensetzung frei sein von Lösemitteln zum Lösen von Festharzen, vorzugsweise flüchtigen Lösemitteln zum Lösen von Festharzen.

Unter Lösemitteln werden vorliegend solche Stoffe verstanden, die andere Stoffe lösen können, ohne hierbei eine chemische Reaktion mit diesen anderen Stoffen einzugehen. Im Stand der Technik dienen Lösemittel beispielsweise dazu, feste Bestandteile wie feste Bindemittel oder feste Harze, in Lösung zu bringen. Flüchtige Lösemittel sind dabei solche Lösemittel, die im ausgehärteten Zustand der Zusammensetzung nicht mehr in der Zusammensetzung vorhanden sind, weil sie sich zwischenzeitlich verflüchtigt haben. Sie werden in keiner Weise in den Lackfilm, der im ausgehärteten Zustand der Zusammensetzung gebildet ist, eingebunden.

Sofern die erfindungsgemäße Zusammensetzung Farbstoffe umfasst, um dem Lötstopplack eine bestimmte Farbe zu geben, kann es sein, dass sich diese Farbstoffe in der Zusammensetzung auflösen (im Gegensatz zu Farbpigmenten, die sich nicht auflösen). Die Farbstoffe lösen sich dann jedoch nicht in einem flüchtigen Lösemittel, welches die Zusammensetzung vorzugsweise ja gerade nicht umfasst, sondern in einem nicht flüchtigen Bestandteil der Zusammensetzung, wie z. B. einem flüssigen Bindemittel oder einem reaktiven Verdünner.

Als reaktive Verdünner werden niedrigviskose Verdünnungen bezeichnet, die über eine Vernetzungsreaktion in den durch die ausgehärtete Zusammensetzung gebildeten Lackfilm eingebunden werden.

## Patentansprüche

1. Lötstopplack zum Aufbringen mittels Tintenstrahltechnologie, wobei die Zusammensetzung des Lötstopplacks eine Wärmebeständigkeit für ein Tintenstrahlsystem besitzt, wobei
die Zusammensetzung wenigstens folgende Komponenten umfasst:
- zumindest ein Monomer mit wenigstens einer kationisch härtbaren Gruppe und/oder zumindest ein Oligomer mit wenigstens einer kationisch härtbaren Gruppe,
- zumindest ein Monomer mit wenigstens einer radikalisch härtbaren Gruppe und/oder zumindest ein Oligomer mit wenigstens einer radikalisch härtbaren Gruppe,
- zumindest ein Monomer mit wenigstens einer thermisch härtbaren Gruppe und/oder zumindest ein Oligomer mit wenigstens einer thermisch härtbaren Gruppe,
- mindestens einen radikalisch initiierenden Fotopolymerisationsinitiator und
- mindestens einen kationisch initiierenden Fotopolymerisationsinitiator,
wobei die Zusammensetzung frei ist von flüchtigen Lösemitteln, die im ausgehärteten Zustand der Zusammensetzung nicht mehr in der Zusammensetzung vorhanden sind, und wobei weiterhin zum einen zumindest eine kationisch härtbare Gruppe ausgewählt ist aus einer Gruppe, welche die cycloaliphatischen Epoxide und die Vinylether umfasst, und zum anderen zumindest eine radikalisch härtbare Gruppe ausgewählt ist aus einer Gruppe, welche die Acrylatester, die Methacrylatester und die Vinylether umfasst, wobei außerdem einerseits die Zusammensetzung Moleküle umfasst, in denen jeweils zumindest eine kationisch härtbare Komponente und wenigstens eine radikalisch härtbare Komponente gemeinsam vorhanden sind und andererseits die einzelnen Komponenten der Zusammensetzung derart ausgewählt und ausgebildet sind, dass der Lötstopplack beim Aushärten ein interpenetrierendes Netzwerk, bestehend aus mindestens zwei Netzwerken, ausbildet.

2. Lötstopplack nach dem vorhergehenden Anspruch, **dadurch gekennzeichnet, dass** zumindest ein Oligomer mit wenigstens einer kationisch härtbaren Gruppe als ein Dimer ausgebildet ist.

3. Lötstopplack nach einem der vorhergehenden Ansprüche, **dadurch gekennzeichnet, dass** zumindest ein Oligomer mit wenigstens einer radikalisch härtbaren Gruppe als ein Dimer ausgebildet ist.

4. Lötstopplack nach einem der vorhergehenden Ansprüche, **dadurch gekennzeichnet, dass** zumindest ein Oligomer mit wenigstens einer thermisch härtbaren Gruppe als ein Dimer ausgebildet ist.

5. Lötstopplack nach einem der vorhergehenden Ansprüche, **dadurch gekennzeichnet, dass** zumindest eine thermisch härtbare Gruppe ausgewählt ist aus einer Gruppe, welche die Epoxide, die Polyole und die stickstoffhaltigen reaktiven Gruppen umfasst.

6. Lötstopplack nach einem der vorhergehenden Ansprüche, **dadurch gekennzeichnet, dass** die Gesamtheit einer kationisch härtbaren Komponente und die Gesamtheit einer radikalisch härtbaren Komponente in entsprechenden Molekülen zusammen vorhanden sind.

7. Lötstopplack nach einem der vorhergehenden Ansprüche, **dadurch gekennzeichnet, dass** die Viskosität der Zusammensetzung (bei 20°C) 10 mPas bis 50 mPas, vorzugsweise 19 mPas, beträgt.

8. Lötstopplack nach einem der vorhergehenden Ansprüche, **dadurch gekennzeichnet, dass** der Anteil des zumindest einen Monomers mit wenigstens einer kationisch härtbaren Gruppe und/oder der Anteil des zumindest einen Oligomers mit wenigstens einer kationisch härtbaren Gruppe an der Zusammensetzung insgesamt 10 Gew.% bis 50 Gew.%, vorzugsweise 28 Gew.%, beträgt.

9. Lötstopplack nach einem der vorhergehenden Ansprüche, **dadurch gekennzeichnet, dass** der Anteil des zumindest einen Monomers mit wenigstens einer radikalisch härtbaren Gruppe und/oder der Anteil des zumindest einen Oligomers mit wenigstens einer radikalisch härtbaren Gruppe an der Zusammensetzung insgesamt 10 Gew.% bis 70 Gew.%, vorzugsweise 35 Gew.%, beträgt.

10. Lötstopplack nach einem der vorhergehenden Ansprüche, **dadurch gekennzeichnet, dass** der Anteil des zumindest einen Monomers mit wenigstens einer kationisch härtbaren Gruppe und/oder der Anteil des zumindest einen Oligomers mit wenigstens einer kationisch härtbaren Gruppe an der Zusammensetzung insgesamt 5 Gew.% bis 30 Gew.%, vorzugsweise 14 Gew.%, beträgt.

11. Lötstopplack nach einem der vorhergehenden Ansprüche, **dadurch gekennzeichnet, dass** der Anteil des zumindest einen radikalisch initiierenden Fotopolymerisationsinitiator an der Zusammensetzung insgesamt 1 Gew.% bis 5 Gew.%, vorzugsweise 3 Gew.%, beträgt.

12. Lötstopplack nach einem der vorhergehenden Ansprüche, **dadurch gekennzeichnet, dass** der Anteil des zumindest einen kationisch initiierenden Fotopolymerisationsinitiator an der Zusammensetzung insgesamt 1 Gew.% bis 5 Gew.%, vorzugsweise 2,5 Gew.%, beträgt.

13. Lötstopplack nach einem der vorhergehenden Ansprüche, **dadurch gekennzeichnet, dass** die Zusammensetzung weiterhin 0,5 Gew.% bis 5 Gew.%, vorzugsweise 1,5 Gew.%, Pigmente und/oder Farbstoffe umfasst.

14. Lötstopplack nach einem der vorhergehenden Ansprüche, **dadurch gekennzeichnet, dass** die Zusammensetzung weiterhin 1 Gew.% bis 5 Gew.%, vorzugsweise 1,5 Gew.%, Additive, wie z. B. Lackadditive wie beispielsweise Netz- und Dispergierhilfsmittel, Entschäumer oder Mittel zur Reduktion der Oberflächenspannung, und/oder Füllstoffe, umfasst.

## Claims

1. Solder resist for applying by means of inkjet technology, wherein the composition of the solder resist has thermal resistance for an inkjet system, and wherein the composition comprises at least the following components:
- at least one monomer with at least one cationically hardenable group, and/or at least one oligomer with cationically hardenable group,
- at least one monomer with at least one radically hardenable group and/or at least one oligomer with at least one radically hardenable group,
- at least one monomer with at least one thermally hardenable group and/or at least one oligomer with at least one thermally hardenable group,
- at least one radically initiating photopolymerisation initiator, and
- at least one cationically initiating photopolymerisation initiator,
wherein the composition is free of volatile solvents, which in the hardened state of the composition are no longer present in the composition, and wherein, furthermore, on the one hand at least one cationically hardenable group is selected from a group comprising the cycloaliphatic epoxides and vinyl ether, and, on the other, at least one radically hardenable group is selected from a group comprising acrylate esters, methacrylate esters, and vinyl ethers, wherein, in addition, on the one hand the composition comprises molecules in which in each case at least one cationically hardenable component and at least one radically hardenable component are present in common, and, on the other hand, the individual components of the composition are selected and formed in such a way that, on hardening, the solder resist forms a interpenetrating network, consisting of at least two networks.

2. Solder resist according to the preceding claim, **characterised in that** at least one oligomer is formed with at least one cationic hardenable group as a dimer.

3. Solder resist according to any one of the preceding claims, **characterised in that** at least one oligomer is formed with at least one radically hardenable group as a dimer.

4. Solder resist according to any one of the preceding claims, **characterised in that** at least one oligomer is formed with at least one thermally hardenable group as a dimer.

5. Solder resist according to any one of the preceding claims, **characterised in that** at least one thermally hardenable group is selected from a group which comprises the epoxides, the polyols, and the reactive groups containing nitrogen.

6. Solder resist according to any one of the preceding claims, **characterised in that** the totality of a cationically hardenable component and the totality of a radically hardenable component are present together in corresponding molecules.

7. Solder resist according to any one of the preceding claims, **characterised in that** the viscosity of the composition (at 20 °C) amounts to 10 mPas to 50 mPas, preferably 19 mPas.

8. Solder resist according to any one of the preceding claims, **characterised in that** the proportion of the at least one monomer with at least one cationic hardenable group and/or the proportion of the at least one oligomer with at least one cationically hardenable group in the composition amounts in total to 10% by weight to 50% by weight, and preferably 28% by weight.

9. Solder resist according to any one of the preceding claims, **characterised in that** the proportion of the at least one monomer with at least one radically hardenable group and/or the proportion of the at least one oligomer with at least one radically hardenable group in the composition amounts in total to 10% by weight to 70% by weight, and preferably 35% by weight.

10. Solder resist according to any one of the preceding claims, **characterised in that** the proportion of the at least one monomer with at least one cationic hardenable group and/or the proportion of the at least one oligomer with at least one cationically hardenable group in the composition amounts in total to 5% by weight to 30% by weight, and preferably 14% by weight.

11. Solder resist according to any one of the preceding claims, **characterised in that** the proportion of the at least one radically initiating photopolymerisation initiator in the composition amounts in total to 1% by weight to 5% by weight, and preferably 3% by weight.

12. Solder resist according to any one of the preceding claims, **characterised in that** the proportion of the at least one radically initiating photopolymerisation initiator in the composition amounts in total to 1% by weight to 5% by weight, and preferably 2.5% by weight.

13. Solder resist according to any one of the preceding claims, **characterised in that** the composition further comprises 0.5% by weight to 5% by weight, and preferably 1.5% by weight, of pigments and/or colouring agents.

14. Solder resist according to any one of the preceding claims, **characterised in that** the composition further comprises 1% by weight to 5% by weight, preferably 1.5% by weight, of additives, such as, for example, paint additives such as crosslinking and dispersion agents, defoaming agents, or agents for the reduction of surface tension, and/or filling substances.

## Revendications

1. Vernis de masquage de brasure conçu pour être appliqué au moyen de la technologie à jet d'encre, la composition dudit vernis de masquage de brasure étant douée de stabilité thermique pour un système à jet d'encre, laquelle composition comprend au moins les composants suivants :
- au moins un monomère comportant au moins un groupe apte au durcissement cationique, et/ou au moins un oligomère comportant au moins un groupe apte au durcissement cationique,
- au moins un monomère comportant au moins un groupe apte au durcissement radicalaire, et/ou au moins un oligomère comportant au moins un groupe apte au durcissement radicalaire,
- au moins un monomère comportant au moins un groupe apte au thermodurcissement, et/ou au moins un oligomère comportant au moins un groupe apte au thermodurcissement,
- au moins un initiateur de photopolymérisation à initiation radicalaire et
- au moins un initiateur de photopolymérisation à initiation cationique,
sachant que la composition est exempte de solvants volatils qui ne sont plus présents dans ladite composition à l'état de durcissement intégral de ladite composition, et sachant par ailleurs que, d'une part, au moins un groupe apte au durcissement cationique est sélectionné au sein d'un groupe incluant les époxydes cycloaliphatiques et les éthers vinyliques et que, d'autre part, au moins un groupe apte au durcissement radicalaire est sélectionné au sein d'un groupe incluant les esters d'acrylate, les esters de méthacrylate et les éthers vinyliques, sachant en outre que, d'une part, la composition comprend des molécules dans lesquelles, à chaque fois, au moins un composant apte au durcissement cationique et au moins un composant apte au durcissement radicalaire sont conjointement présents et que, d'autre part, les composants individuels de ladite composition sont sélectionnés et conçus de façon telle que ledit vernis de masquage de brasure donne naissance, lors du durcissement intégral, à un réseau interpénétrant constitué d'au moins deux réseaux.

2. Vernis de masquage de brasure, selon la revendication précédente, **caractérisé par le fait qu'**au moins un oligomère comportant au moins un groupe apte au durcissement cationique est conçu sous la forme d'un dimère.

3. Vernis de masquage de brasure, selon l'une des revendications précédentes, **caractérisé par le fait qu'**au moins un oligomère comportant au moins un groupe apte au durcissement radicalaire est conçu sous la forme d'un dimère.

4. Vernis de masquage de brasure, selon l'une des revendications précédentes, **caractérisé par le fait qu'**au moins un oligomère comportant au moins un groupe apte au thermodurcissement est conçu sous la forme d'un dimère.

5. Vernis de masquage de brasure, selon l'une des revendications précédentes, **caractérisé par le fait qu'**au moins un groupe thermodurcissable est sélectionné au sein d'un groupe incluant les époxydes, les polyols et les groupes réactifs azotés.

6. Vernis de masquage de brasure, selon l'une des revendications précédentes, **caractérisé par le fait que** l'intégralité d'un composant apte au durcissement cationique, et l'intégralité d'un composant apte au durcissement radicalaire, sont conjointement présentes dans des molécules correspondantes.

7. Vernis de masquage de brasure, selon l'une des revendications précédentes, **caractérisé par le fait que** la viscosité de la composition (à 20 °C) mesure de 10 mPas à 50 mPas, 19 mPas de préférence.

8. Vernis de masquage de brasure, selon l'une des revendications précédentes, **caractérisé par le fait que** la part constitutive du monomère à présence minimale comportant au moins un groupe apte au durcissement cationique, et/ou la part constitutive de l'oligomère à présence minimale comportant au moins un groupe apte au durcissement cationique, représente(nt) au total de 10 % en poids à 50 % en poids, de préférence 28 % en poids dans la composition.

9. Vernis de masquage de brasure, selon l'une des revendications précédentes, **caractérisé par le fait que** la part constitutive du monomère à présence minimale comportant au moins un groupe apte au durcissement radicalaire, et/ou la part constitutive de l'oligomère à présence minimale comportant au moins un groupe apte au durcissement radicalaire, représente(nt) au total de 10 % en poids à 70 % en poids, de préférence 35 % en poids dans la composition.

10. Vernis de masquage de brasure, selon l'une des revendications précédentes, **caractérisé par le fait que** la part constitutive du monomère à présence minimale comportant au moins un groupe apte au durcissement cationique, et/ou la part constitutive de l'oligomère à présence minimale comportant au moins un groupe apte au durcissement cationique, représente(nt) au total de 5 % en poids à 30 % en poids, de préférence 14 % en poids dans la composition.

11. Vernis de masquage de brasure, selon l'une des revendications précédentes, **caractérisé par le fait que** la part constitutive de l'initiateur de photopolymérisation à initiation radicalaire, à présence minimale, représente au total de 1 % en poids à 5 % en poids, de préférence 3 % en poids dans la composition.

12. Vernis de masquage de brasure, selon l'une des revendications précédentes, **caractérisé par le fait que** la part constitutive de l'initiateur de photopolymérisation à initiation cationique, à présence minimale, représente au total de 1 % en poids à 5 % en poids, de préférence 2,5 % en poids dans la composition.

13. Vernis de masquage de brasure, selon l'une des revendications précédentes, **caractérisé par le fait que** la composition comprend, par ailleurs, de 0,5 % en poids à 5 % en poids, de préférence 1,5 % en poids de pigments et/ou de colorants.

14. Vernis de masquage de brasure, selon l'une des revendications précédentes, **caractérisé par le fait que** la composition comprend, par ailleurs, de 1 % en poids à 5 % en poids, de préférence 1,5 % en poids d'additifs tels que, par exemple, des additifs pour peintures comme, par exemple, des auxiliaires mouillants et dispersants, des antimoussants ou des agents de réduction de la tension superficielle, et/ou des substances de charge.
